Europäisches Patentamt

European Patent Office

Office européen des brevets

(19)

(11) Numéro de publication : **0 371 065 B1**

(12)

# FASCICULE DE BREVET EUROPEEN

(45) Date de publication du fascicule du brevet :
**13.05.92 Bulletin 92/20**

(51) Int. Cl.⁵ : **C23C 16/44,** C23C 16/46

(21) Numéro de dépôt : **88907010.8**

(22) Date de dépôt : **20.07.88**

(86) Numéro de dépôt international :
**PCT/FR88/00372**

(87) Numéro de publication internationale :
**WO 89/01054 09.02.89 Gazette 89/04**

(54) **REACTEUR DE DEPOT OU DE TRAITEMENT DE SURFACE.**

(30) Priorité : **27.07.87 FR 8710666**

(43) Date de publication de la demande :
**06.06.90 Bulletin 90/23**

(45) Mention de la délivrance du brevet :
**13.05.92 Bulletin 92/20**

(84) Etats contractants désignés :
**AT BE CH DE FR GB IT LI LU NL SE**

(56) Documents cités :
**EP-A- 0 137 702
EP-A- 0 178 200
US-A- 4 615 294
Patent Abstracts of Japan, vol. 10, no. 31 (
C-327 ) ( 2088 ) 6 Feb. 1986 & JP,A,60184679**

(73) Titulaire : **CEPICA S.A.
33 rue Roquelaine
F-31000 Toulouse (FR)**
Titulaire : **CENTRE NATIONAL DE LA
RECHERCHE SCIENTIFIQUE (CNRS)
15, Quai Anatole France
F-75700 Paris Cedex 07 (FR)**

(72) Inventeur : **BARALE, Gilbert
2, rue Montcalm
F-31120 Roquettes (FR)**
Inventeur : **IZARD, Jean-Claude
Aucamville
F-82600 Verdun-sur-Garonne (FR)**
Inventeur : **RIZZETTO, François Place de
l'Eglise
Fontenilles
F-31470 Saint-Lys (FR)**
Inventeur : **COUDERC, Jean-Pierre
26, rue Rouvière
F-31100 Toulouse (FR)**
Inventeur : **GACHEN, Christian
12, allée des Acacias
F-31500 Toulouse (FR)**
Inventeur : **MORANCHO, Roland
69, rue Pierre-Cazeneuve
F-31200 Toulouse (FR)**

(74) Mandataire : **Barre, Philippe
Cabinet Barre-Gatti-Laforgue 95 rue des
Amidonniers
F-31069 Toulouse Cédex (FR)**

## Description

L'invention concerne un réacteur de dépôt ou traitement de surface, permettant de revêtir des substrats de films minces ou d'opérer un traitement de surface de ceux-ci ; elle vise en particulier un réacteur de dépôt chimique en phase vapeur ("Chemical Vapor Deposition : CVD") et peut notamment s'appliquer à la fabrication de composants électroniques ou de circuits intégrés : revêtement de plaquettes de films minces conducteurs, semi-conducteurs ou isolants (par exemple formation ou dopage de films épitaxiques, polycristallins ou amorphes de matériaux tels que silicium, germanium, arséniure de gallium...). Le réacteur conforme à l'invention peut également s'appliquer pour effectuer des traitements de nitruration, oxydation ou autres en surface des substrats ou encore pour effectuer des dépôts par pulvérisation cathodique...

Par exemple, le procédé de dépôt chimique en phase vapeur est utilisé à l'heure actuelle pour déposer des matériaux divers sur des substrats dans de nombreuses applications : secteur électronique comme ci-dessus évoqué, secteur mécanique pour réaliser des revêtements résistant à la corrosion ou des revêtements résistant à l'abrasion, secteur nucléaire... Ce procédé qui implique généralement une décomposition thermique, une oxydation chimique ou une réduction chimique consiste à amener une phase gazeuse à circuler à faible pression au contact des substrats à revêtir, portés à une température précise appropriée (le plus fréquemment entre 400° C et 800° C) ; cette phase gazeuse est constitué par un gaz vecteur contenant le ou les composés réactifs.

Les caractéristiques des dépôts obtenus (nature, uniformité...) sont influencées par plusieurs facteurs et en particulier par la distribution de température et par les caractéristiques de l'écoulement au niveau des substrats. Le contrôle de la température est généralement une condition primordiale pour maîtriser les dépôts réalisés et, dans de nombreuses applications, une variation de quelques degrés suffit pour perturber les résultats obtenus.

Pour améliorer la rentabilité du procédé, il est souhaitable de traiter à chaque passe un grand nombre de substrats, notamment dans le domaine électronique où ceux-ci se présentent sous la forme de minces plaquettes circulaires, et les réacteurs CVD traditionnels illustrés par exemple par le brevet DE 3 134 702 comprennent une enceinte de forme allongée dans laquelle est disposée une série de substrats, rangés côte à côte depuis une extrémité de l'enceinte où la phase gazeuse est introduite jusqu'à l'extrémité opposée où ladite phase gazeuse est aspirée. Toutefois, il n'est pas possible dans ce type de réacteur de maîtriser parfaitement les dépôts obtenus sur tous les substrats dès que leur nombre devient élevé (par exemple, au-delà d'une centaine pour des plaquettes électroniques). En effet, les substrats sont balayés successivement par le flux gazeux qui s'épuise en composés réactifs au cours de son parcours, conduisant à un traitement différent selon la place du substrat.

Pour réduire le défaut sus-évoqué, ont été conçus des réacteurs dans lesquels la phase gazeuse balaie tous les substrats simultanément, et non successivement. Par exemple, les brevet US 4 524 719 et brevet EP 0 137 702 décrivent un réacteur dans lequel les substrats sont agencés dans une chambre de réaction en position verticale parallèle au trajet du gaz CVD. Toutefois, d'une part, l'uniformité de température dans la chambre de réaction est très difficile à maîtriser dans ce type de réacteurs, d'autre part, la contenance de ladite chambre de réaction est nécessairement faible, le nombre de substrats traités étant très limité, sous peine que les écoulements gazeux dans la chambre deviennent totalement incontrôlables et qu'apparaissent des gradients de température inacceptables.

Il est à noter que le brevet JP-A-60.184679 décrit un réacteur comprenant deux chambres constituées par une première enceinte qui est insérée dans une seconde enceinte en forme de cloche : la première enceinte forme la chambre de réaction et contient les substrats et les moyens de chauffage ; un distributeur de gaz à plusieurs tubes est prévu le long de l'axe des deux enceintes et peut être déplacé axialement pour permettre de distribuer tel ou tel gaz vers la chambre de réaction selon le dépôt à réaliser. Ce réacteur permet ainsi de faciliter la réalisation du dépôt à couches multiples mais n'apporte aucune solution au problème du contrôle de la distribution des températures et de l'écoulement dans la chambre de réaction.

La présente invention se propose de fournir un nouveau réacteur de dépôt en phase vapeur, apportant une solution satisfaisante au problème ci-dessus évoqué.

D'une façon plus générale, l'invention vise à fournir un nouveau réacteur de dépôt ou de traitement de surface par mise en oeuvre de tout procédé connu impliquant un apport thermique et un balayage au moyen d'une phase gazeuse, l'objectif de l'invention étant de permettre le traitement d'un nombre élevé de substrats (sans limite théorique), tout en gardant une parfaite maîtrise de la distribution des températures et de l'écoulement afin d'obtenir un traitement ou dépôt de type souhaité, identiques pour tous les substrats.

Un autre objectif est de fournir un réacteur bénéficiant d'une grande souplesse de mise en oeuvre, notamment pour opérer les chargements et déchargements des substrats.

Un autre objectif est de fournir un réacteur bien adapté pour être implanté dans des salles blanches, en particulier en vue de la fabrication de composants ou de circuits électroniques par mise en oeuvre du procédé CVD.

L'invention s'étend à tout réacteur de dépôt ou traitement de surface, et en particulier dans le cas d'un dépôt en phase vapeur au dépôt chimique en phase vapeur (CVD), mais aussi dépôt physique en phase vapeur ("Physical. Vapor Deposition : PVD"), ces dépôts pouvant ou non être assistés par des aides classiques (plasmas, rayonnements...).

Le réacteur, de dépôt ou traitement de surface conforme à l'invention comprend en combinaison :

– une première paroi tubulaire, dite paroi interne, chimiquement stable à haute température, s'étendant autour d'un axe longitudinal. (X) et délimitant intérieurement un volume dit volume central,

– une seconde paroi tubulaire, dite paroi externe, chimiquement stable à haute température, s'étendant autour de la première paroi tubulaire pour délimiter avec celle-ci une chambre annulaire de réaction,

– deux parois de fermeture, agencées pour pouvoir obturer étanchément ladite chambre annulaire à ses deux extrémités longitudinales,

– une enceinte périphérique s'étendant autour de la paroi tubulaire externe sur au moins une fraction de la hauteur de celle-ci,

– des moyens de distribution de gaz, adaptés pour délivrer une phase gazeuse à l'intérieur de la chambre annulaire de réaction au voisinage d'une des parois de fermeture, dite paroi amont, lesdits moyens de distribution étant agencés pour répartir ladite phase gazeuse sur 360° dans ladite chambre annulaire,

– des moyens d'aspiration, agencés pour aspirer la phase gazeuse après réaction au voisinage de la paroi de fermeture opposée, dite paroi aval, de façon à préserver la répartition en couronne de l'écoulement gazeux à l'intérieur de la chambre annulaire de réaction,

– un premier ensemble de chauffage agencé à l'intérieur du volume central de façon à pouvoir transmettre vers la paroi tubulaire interne un flux calorifique réparti sur 360°,

– un second ensemble de chauffage disposé dans l'enceinte périphérique de façon à pouvoir transmettre vers la paroi tubulaire externe un flux calorifique réparti sur 360°,

– des moyens de régulation thermique, adaptés pour asservir les premier et second ensembles de chauffage de sorte que les flux calorifiques transmis à travers les parois interne et externe tendent à assurer un profil longitudinal de température prédéterminé dans la chambre annulaire de réaction sur une portion de la hauteur de celle-ci, dite portion de travail,

– un support de substrats, de forme adaptée pour se loger dans la chambre annulaire de réaction et pour positionner les substrats dans la portion de travail de ladite chambre annulaire.

Un tel réacteur à chambre de réaction annulaire autorise une maîtrise fine du profil de température dans la zone de travail grâce à un asservissement approprié de ses premier et second ensembles de chauffage. De plus, il peut être aisément adapté pour traiter un nombre élevé désiré de substrats, par un simple ajustement approprié des rayons des première et seconde parois annulaires, et ce, tout en autorisant un écoulement sensiblement uniforme de la phase gazeuse dans la chambre annulaire de réaction grâce à une répartition convenable de cette phase par les moyens de distribution de gaz.

Les substrats agencés en couronne dans la chambre annulaire de réaction sont disposés en une couche unique ou en un nombre de couches suffisamment limité pour que la modification de la phase gazeuse soit insensible entre la première et la dernière couche balayée. En pratique, le nombre de couches pourra être égal. à 1 dans de nombreuses applications, de sorte que tous les substrats soient balayés simultanément ou à peu près simultanément par la phase gazeuse.

Dans le cas de substrats constitués par des plaquettes d'épaisseur faible par rapport aux autres dimensions, celles-ci peuvent être avantageusement disposées sur un support de forme générale annulaire, délimitant sur son pourtour une pluralité de logements, chacun adapté au maintien d'une plaquette en position radiale ou voisine de la position radiale. Par exemple, lesdites plaquettes peuvent être maintenues individuellement par des guides circulaires, solidarisés par des entretoises à des piétements ; ces guides pourvus d'encoches sur leur pourtour sont dimensionnés pour se loger dans la chambre de réaction annulaire, et maintiennent par leurs encoches chaque plaquette en position radiale. Dans le secteur électronique, les plaquettes à revêtir par CVD sont souvent prépositionnées par lots sur des nacelles linéaires où elles sont rangées dans des plans parallèles. Le cas échéant, il est possible de conserver ces nacelles, le support de substrats comprenant alors un bâti annulaire ajouré, pourvu sur son pourtour de moyens de positionnement d'une pluralité desdites nacelles ; chaque nacelle est disposée tangentiellement dans la chambre annulaire de réaction de sorte que sa plaquette centrale se trouve en position radiale, les autres plaquettes s'écartant de quelques degrés de cette position.

Les ensembles de chauffage disposés l'un dans le volume central à l'intérieur de la paroi tubulaire interne, l'autre dans l'enceinte périphérique autour de la parai tubulaire externe, peuvent être de tout type : chauffage électrique résistif ou par induction, chauffage par lits fluidisés, etc... ; toutefois on préférera en pratique des ensembles de chauffage de nature électrique en raison de leur plus grande facilité d'asservissement par des moyens de régulation de type connu en soi. Généralement, les deux ensembles de chauffage seront constitués par des éléments actifs indépendants ( résistances électriques...) ; toutefois l'un de ces ensembles peut le cas échéant être passif et constitué par un moyen de réflexion annulaire renvoyant le rayonnement thermique vers la chambre de réaction.

Les moyens de régulation thermique, appelés à asservir lesdits premier et second ensembles de chauffage, comprennent, d'une part, des capteurs de température, connus en soi, répartis sur la paroi tubulaire interne et sur la paroi tubulaire externe, d'autre part, une unité d'asservissement adaptée pour commander les ensembles de chauffage en fonction des informations de température issues des capteurs, de façon à obtenir le profil de température désiré dans la chambre annulaire de réaction (ce profil étant préalablement mémorisé dans ladite unité d'asservissement sous la forme d'une ou d'un ensemble de températures de consigne).

Par ailleurs, selon un premier mode de réalisation, les moyens de distribution de gaz et les moyens d'aspiration débouchent dans la chambre de réaction annulaire à travers les parois de fermeture opposées qui obturent celle-ci à ses deux extrémités ; ces moyens sont alors constitués par des réseaux de conduits (réseau de conduits de répartition ou réseau de conduits d'aspiration) répartis autour de l'axe longitudinal du réacteur aux deux extrémités de celui-ci et reliés à un conduit principal (conduit d'arrivée de la phase gazeuse au collecteur de pompage). Au mains l'un de ces conduits principaux est un conduit souple afin d'autoriser le démontage de la paroi de fermeture correspondante en vue de charger ou décharger les substrats.

Selon un autre mode de réalisation, les moyens de distribution de gaz et les moyens d'aspiration sont situés d'un même côté du réacteur et pénétrent dans celui-ci par l'une de ses extrémités longitudinales. Dans ce cas, l'une des fonctions (distribution ou aspiration) est comme précédemment assurée par un réseau de conduits débouchant dans la chambre à travers l'une des parois de fermeture, mais l'autre fonction (aspiration ou distribution) est assurée par un collecteur qui pénétre dans le volume central du côté de ladite paroi de fermeture et s'étend le long de ce volume central pour déboucher à travers un fond obturant ledit volume en regard de l'autre paroi de fermeture : la phase gazeuse peut ainsi s'écouler dans l'espace séparant ce fond et cette paroi, entre la chambre annulaire de réaction et le collecteur. De la sorte, dans ce mode de réalisation, l'une des parois de fermeture et l'extrémité longitudinale correspondante du réacteur sont exemptes de tout équipement de distribution et d'aspiration, ce qui facilite notablement l'implantation du réacteur dans une salle blanche : cette extrémité longitudinale sera agencée pour déboucher dans la salle blanche de façon à permettre le chargement et le déchargement des substrats dans des conditions de propreté requises, cependant que l'extrémité opposée du réacteur (dotée des équipements de distribution et d'aspiration) sera située en dehors de la salle blanche de façon que ces équipements soient disposés à l'extérieur de celle-ci.

En outre, l'une des parois de fermeture (paroi exempte d'équipements dans le mode de réalisation sus-évoqué ou paroi associée à un conduit souple dans l'autre mode de réalisation) est avantageusement prévue mobile dans le sens longitudinal et portée par des moyens de translation permettant de la déplacer entre une position de travail où ladite paroi obture étanchément la chambre annulaire de réaction et une position de chargement où ladite paroi est écartée de l'extrémité de ladite chambre et laisse celle-ci ouverte. Le support de substrats porté par ladite paroi se déplace ainsi avec celle-ci entre une position de travail intérieure à la chambre annulaire de réaction et une position de chargement extérieure à celle-ci.

Dans une version perfectionnée, une platine annulaire tournante est associée à ladite paroi de fermeture de façon à pouvoir amener le support de substrat à tourner autour de l'axe longitudinal du réacteur, soit en cours de traitement, soit au cours des chargements et déchargements en vue d'automatiser ces opérations.

L'invention peut tout particulièrement s'appliquer pour effectuer des dépôts chimiques en phase vapeur (CVD) de films conducteurs, semi-conducteurs ou isolants en vue de la fabrication de composants ou circuits électroniques. Dans cette application, la paroi tubulaire interne et la paroi tubulaire externe sont des parois cylindriques en matériau réfractaire de haute stabilité thermique tel que quartz, le support de substrats étant lui-même en matériau réfractaire de haute stabilité thermique tel que quartz.

Dans le cas de dépôts assistés, la chambre annulaire de réaction est équipée des moyens classiques d'aide au dépôt : électrodes de production de plasma, générateur de rayonnement (ultraviolet, microonde )...

D'autres caractéristiques, buts et avantages de l'invention ressortiront de la description qui suit en' référence aux dessins annexés, lesquels en présentent à titre d'exemples non limitatifs deux modes de réalisation ; sur ces dessins qui font partie intégrante de la présente description :

– la figure 1 est une coupe axiale par un plan vertical. AA' d'un premier mode de réalisation de réacteur,
– la figure 2 en est une coupe transversale par un plan horizontal. BB',
– les figures 3 et 4 sont respectivement des vues de dessous et de dessus dudit réacteur,
– la figure 5 est une coupe axiale par un plan vertical. CC' d'un autre mode de réalisation de réacteur,

– la figure 6 est une coupe d'un détail de la figure 5 à échelle plus grande,

– la figure 7 est une coupe transversale par un plan horizontal. DD' dudit réacteur,

– la figure 8 est une coupe partielle de détail du support de substrats, équipant ledit réacteur.

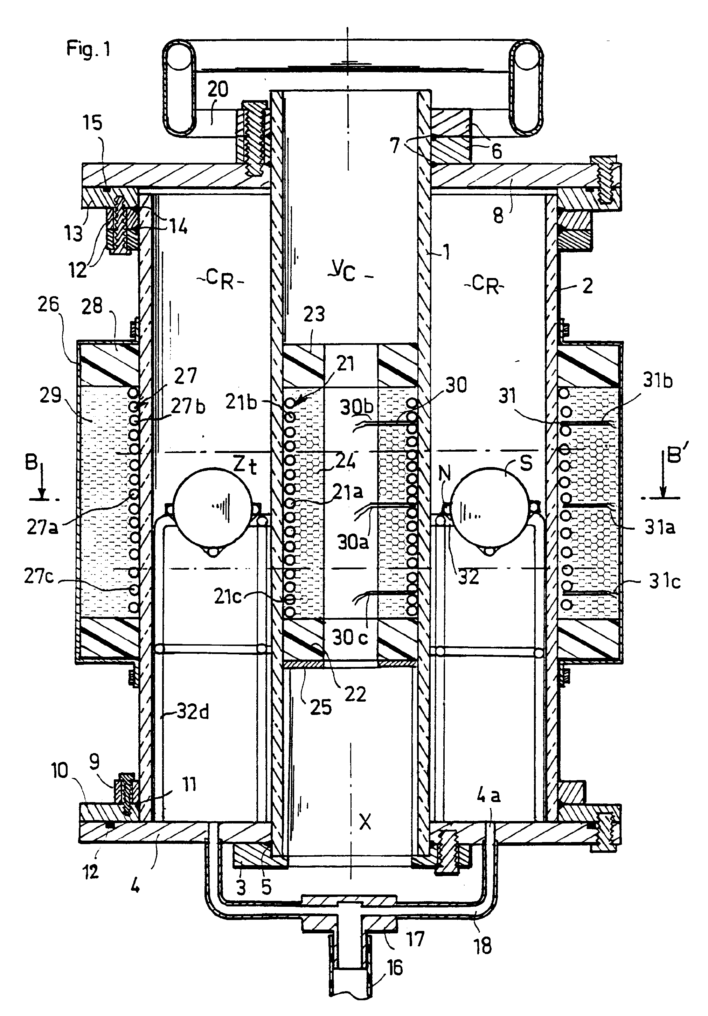

Le réacteur de dépôt chimique en phase vapeur représenté à titre d'exemple aux figures 1 à 4 s'étend le long d'un axe longitudinal vertical X et comprend une chambre annulaire de réaction $C_R$ située autour et le long de cet axe. Cette chambre $C_R$ est essentiellement délimitée par deux parois cylindriques, interne 1 et externe 2, en quartz ou matériau réfractaire analogue de haute stabilité thermique.

La paroi interne délimite intérieurement un volume central cylindrique $V_C$ s'étendant le long de l'axe X. Cette paroi est portée en partie basse (zone froide du réacteur) par une bride 3 en acier qui est boulonnée sous une paroi de fermeture 4, dite paroi amont, obturant la chambre annulaire de réaction $C_R$ à son extrémité basse ; un joint 5 assure l'étanchéité.

En partie haute (zone froide), la paroi interne 1 est insérée dans des brides 6 avec interposition de joints d'étanchéité tels que 7 ; ces brides sont boulonnées sur une autre paroi de fermeture 8, dite paroi aval, obturant la chambre annulaire de réaction $C_R$ à son extrémité haute.

La paroi externe 2 coopère, de façon analogue, en partie basse et en partie haute, avec des brides annulaires, avec interposition de joints d'étanchéité : en partie basse, brides 9 et 10 guidant un joint 11, joint 12 entre la paroi amont 4 et la bride 10 ; en partie haute, brides 12 et 13 guidant des joints 14, joint 15 entre la paroi aval 8 et la bride 13.

De façon classique, les brides et parois de fermeture peuvent être équipées de moyens de circulation d'un fluide de refroidissement, évitant tout échauffement excessif de ces zones froides.

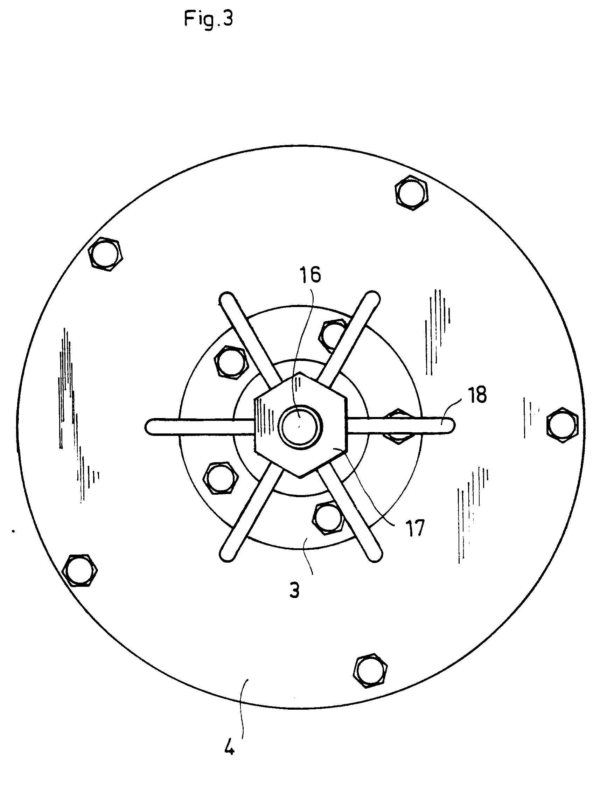

Dans le mode de réalisation décrit, à la paroi amont 4 sont associés des moyens de distribution de gaz, comprenant essentiellement un conduit d'arrivée souple 16 qui est relié à un raccard central. 17 d'où s'échappent un réseau de conduits de répartition 18 agencés en étoile en regard et au-dessous de la parai amont 4. Chaque conduit de répartition 18 est fixé à la paroi 4 et débouche dans une lumière d'entrée telle que 4a ménagée dans ladite paroi Les conduits 18 sont régulièrement répartis autour de l'axe X et débauchent dans la chambre annulaire de réaction $C_R$ approximativement sur un rayon moyen entre le rayon de la paroi interne 1 et celui de la paroi externe 2 ; en l'exemple représenté (figure 3), les conduits de répartition 18 sont au nombre de six, angulairement distants de 60°.

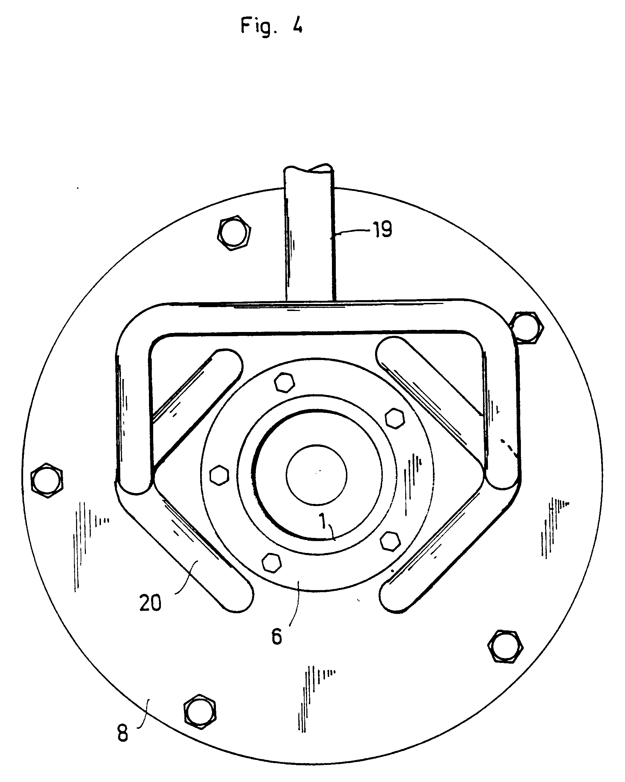

A la paroi de fermeture aval 8 sont associés des moyens d'aspiration comprenant essentiellement un collecteur de pompage 19 relié à un réseau de conduits d'aspiration tels que 20 agencés en regard et au-dessus de la paroi aval 8. Comme précédemment, les conduits d'aspiration 20 sont connectés à des lumières de sortie ménagées dans ladite paroi aval. 8 ; ces lumières sont réparties autour de l'axe X pour déboucher dans la chambre annulaire de réaction $C_R$ approximativement sur le rayon moyen de celle-ci. En l'exemple représenté (figure 4), les conduits d'aspiration sont au nombre de quatre, débouchant dans la chambre $C_R$ par des lumières angulairement distantes de 90°.

Par ailleurs, dans sa zone médiane, le volume central. $V_C$ contient un premier ensemble de chauffage comprenant des résistances électriques 21 enroulées en spires à l'intérieur et à proximité immédiate ou au contact de la paroi interne 1. Ces résistances sont disposées entre deux manchons isolants 22 et 23 et sont agencées pour rayonner vers la paroi 1, une couche annulaire d'un matériau isolant 24 apte à supporter des températures élevées réduisant les déperditions dans le sens centripète.

Cet ensemble de chauffage qui est glissé dans le volume central $V_C$ le long de la paroi interne 1 est maintenu dans la zone médiane du volume $V_C$ par une bague symbolisée en 25, dotée de pieds en appui sur la bride 3.

Autour de la paroi externe 2, est disposé un second ensemble de chauffage analogue au premier, qui est logé dans une enceinte périphérique 26 s'étendant sur une fraction de la hauteur de la paroi 2, dans la zone médiane de celle-ci, de sorte que les deux ensembles de chauffage soient situés au même niveau. Comme précédemment, ce second ensemble de chauffage comprend des résistances électriques 27 enroulées en spires à l'extérieur et à proximité immédiate au au contact de la paroi externe 2, des manchons isolants 28 et une couche annulaire 29 d'un matériau isolant réduisant les déperditions dans le sens centrifuge.

Chaque ensemble de chauffage est divisé en plusieurs sous-ensembles longitudinalement juxtaposés, qui sont commandés séparément par une unité d'asservissement (non représentée). En l'exemple, notamment dans le but de réaliser une homogénéité de température dans une portion de travail. $Z_t$ de la chambre $C_R$ (délimitée par deux lignes en traits discontinus à la figure 1), chaque ensemble de chauffage est divisé en trois sous-ensembles juxtaposés, comprenant l'un des spires résistives intermédiaires telles que 21a ou 27a situées approximativement au niveau de la portion de travail $Z_t$, et les deux autres des spires marginales telles que 21b ou 27b au-dessus des premières, et 21c ou 27c au-dessous de celles-ci.

Des capteurs de température 30 et 31 sont associés à chaque ensemble de chauffage et disposés sur la surface de la paroi interne 1 et sur celle de la paroi externe 2 afin de fournir une information de température. Pour chaque ensemble de chauffage, il est prévu plusieurs capteurs 30 ou 31 positionnés au niveau des divers sous-ensembles de chauffage : par exemple capteurs 30a ou 31a associés aux spires 21a ou 27a ; capteurs 30b ou 31b associés aux spires 21b ou 27b ; capteurs 30c ou 31c associés aux spires 21c ou 27c. Bien entendu à chaque niveau, plusieurs capteurs peuvent être répartis autour des spires, l'information prise en compte pouvant être une information moyenne.

Les capteurs 30 et 31 délivrent leurs signaux de température vers l'unité d'asservissement déjà évoquée qui est constituée par des circuits classiques d'asservissement aptes à réguler l'alimentation électrique des divers sous-ensembles de chauffage en fonction des informations de température issues des capteurs correspondants.

En l'exemple visé où l'on recherche une homogénéité de température dans la portion de travail $Z_t$, l'unité d'asservissement est adaptée pour augmenter le flux calorifique fourni par chaque sous-ensemble de chauffage en cas d'écart négatif entre la température détectée au niveau dudit sous-ensemble et une température de consigne, identique pour tous les sous-ensembles, et pour réduire ce flux dans le cas contraire.

Bien entendu, l'unité d'asservissement est, dans chaque application, programmée en fonction du profil de températures désiré. Il est en particulier possible de diviser les ensembles de chauffage 21 et 27 en un nombre plus élevé de sous-ensembles, et d'affecter à chacun d'eux une température de consigne propre, l'asservissement ajustant l'alimentation des spires correspondantes afin de réduire pour chaque sous-ensemble les écarts entre la température détectée et sa température de consigne.

La forme annulaire de la chambre de réaction $C_R$, la présence des deux ensembles de chauffage, interne 21 et externe 29, et leur extension le long de l'axe longitudinal X, avec le cas échéant séparation en plusieurs sous-ensembles régulés indépendamment, permettent de contrôler le profil de température dans la portion de travail de la chambre $C_R$ dans de remarquables conditions de précision.

Les substrats à revêtir, en l'exemple de minces plaquettes circulaires 5, sont positionnés dans cette portion de travail au moyen d'un support 32 de forme générale annulaire. Ce support repose sur la paroi de fermeture 4 et peut être retiré par démontage de cette paroi.

En l'exemple, le support 32 est réalisé en quartz et comprend un bâti annulaire adapté pour permettre la mise en place de plusieurs nacelles N de type traditionnel, elles-mêmes en quartz, qui soutiennent les plaquettes 5 (en général 25 plaquettes par nacelle). Chaque nacelle vient en appui sur des entretoises supérieures 32a du bâti 32, qui relient des membrures circulaires 32b et 32c, montées sur des piètements tels que 32d.

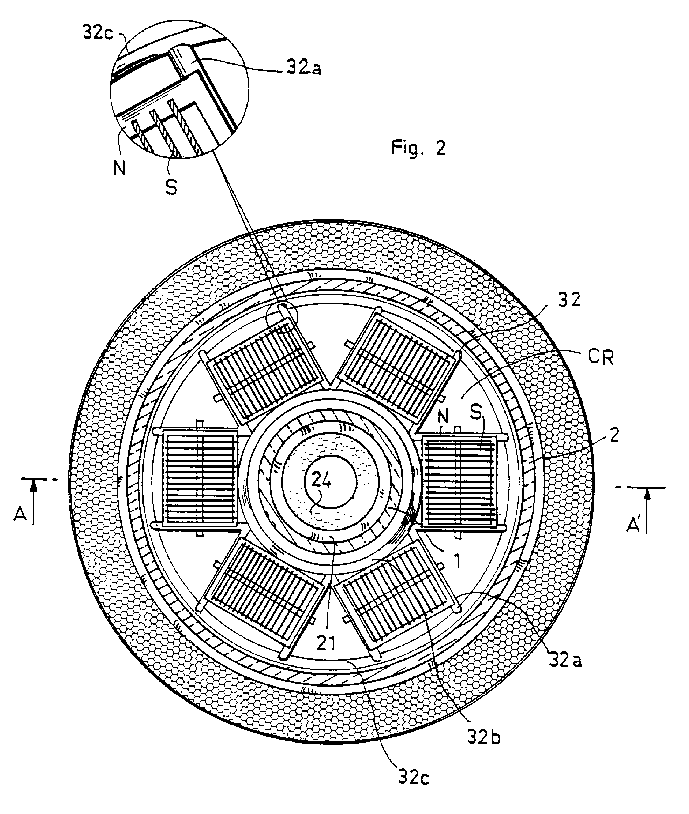

La plaquette centrale de chaque nacelle se trouve positionnée dans un plan vertical radial comme le schématise la figure 2, cependant que les autres plaquettes de la même nacelle sont situées dans des plans verticaux parallèles.

Le flux gazeux réparti sur 360° à la base de la chambre annulaire de réaction $C_R$ et aspiré en partie haute sans perturbation notable de cette répartition, lèche toutes les plaquettes simultanément et de façon homogène, ce qui garantit une excellente uniformité de traitement de toutes les plaquettes quel que soit leur nombre. Il est à noter qu'il est possible de disposer plusieurs couches superposées de plaquettes sur un support approprié à plusieurs étages avec un résultat satisfaisant.

La répartition homogène de l'écoulement et la précision du contrôle des températures sont obtenues, de la même façon, quel que soit le rayon moyen de la chambre annulaire de réaction $C_R$. Ainsi, le réacteur de l'invention peut être dimensionnellement adapté au nombre de substrats à traiter par un simple choix approprié de ce rayon moyen qui peut varier de quelques dizaines de centimètres à quelques mètres.

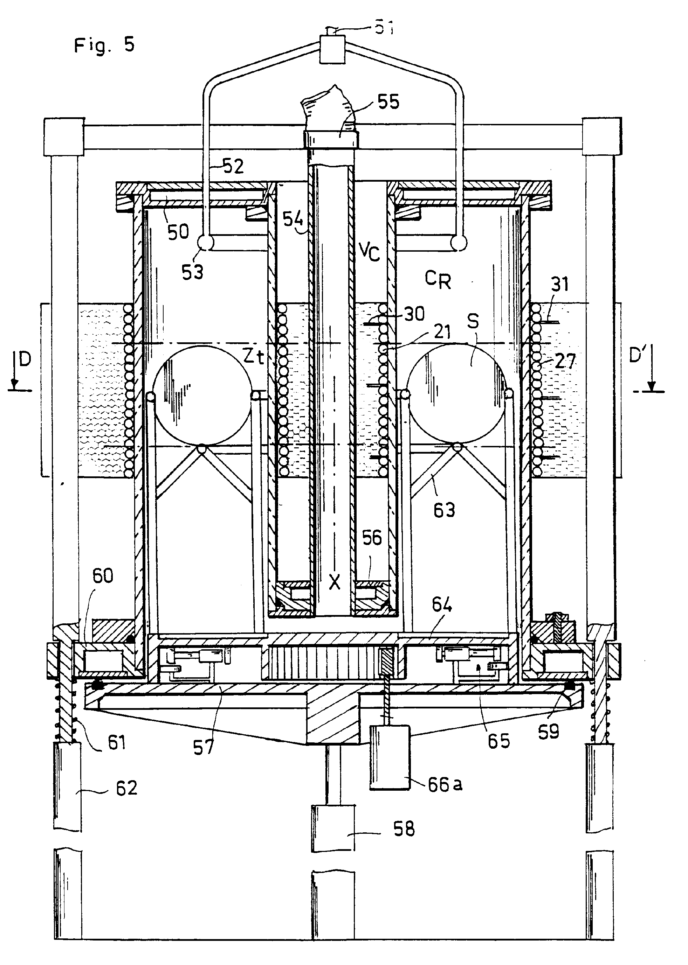

Par ailleurs, les figures 5, 6, 7 et 8 visent un autre mode de réalisation du réacteur. Pour faciliter la compréhension, on a repris les mêmes références pour les organes identiques ou analogues : parois cylindriques, interne 1 et externe 2, en quartz délimitant une chambre de réaction annulaire $C_R$ et un volume central. $V_C$, premier ensemble de chauffage 21 dans le volume central. $V_C$, second ensemble de chauffage 27 autour de la paroi externe 2, capteurs de température 30 et 31...

Dans cet exemple, les moyens de distribution de la phase gazeuse distribuent celle-ci à travers la paroi de fermeture supérieure 50 (qui devient la paroi amont), cette paroi étant creuse pour permettre la circulation d'un fluide de refroidissement. Comme précédemment, ces moyens de distribution comprennent un conduit général d'arrivée 51 relié à un réseau de conduits de répartition 52 connectés à des entrées qui sont ménagées dans la paroi de fermeture et répartis autour de l'axe longitudinal pour déboucher dans la chambre annulaire de réaction. En l'exemple, une rampe 53 percée sur son pourtour d'une pluralité de lumières assure la distribution dans la chambre $C_R$.

Les moyens d'aspiration sortent du réacteur du côté de la paroi amont 50 et comprennent un collecteur de pompage 54 relié par un raccord 55 à un conduit souple connecté à une pompe à vide. Le collecteur 54 pénètre dans le volume central. $V_C$ du côté de la paroi 50, et s'étend le long de l'axe longitudinal vertical. X sur la longueur de ce volume. En partie basse, il traverse un fond étanche 56 obturant le volume central. $V_C$, pour déboucher en regard et au-dessus de la paroi de fermeture aval qui sera décrite plus loin. Le fond 56 est équipé d'un joint pour assurer l'étanchéité avec la paroi interne 1 ; ce fond est avantageusement prévu creux pour autoriser la circulation d'un fluide de refroidissement.

Ainsi, dans ce mode de réalisation, la paroi de fermeture inférieure (aval) est exempte de tout équipement de distribution ou de pompage. La phase gazeuse est aspirée en partie basse de la chambre annulaire de réaction $C_R$ entre le fond 56 et la paroi inférieure de fermeture, depuis ladite chambre $C_R$ vers le collecteur 54.

Il est à noter que, dans une variante, il est également possible d'inverser distribution et aspiration, tout en gardant une extrémité du réacteur dégagée de tout équipement : la distribution sera alors assurée par un collecteur de distribution pénétrant dans le volume central du côté de la paroi de fermeture aval et s'étendant le long dudit volume central pour déboucher à travers un fond similaire au fond 56 ; la phase gazeuse est alors distribuée vers la chambre annulaire de réaction $C_R$ en s'écoulant dans le sens centrifuge entre ledit fond et la paroi de fermeture ; l'aspiration quant à elle est assurée par un collecteur de pompage et des conduits d'aspiration comme précédemment.

Par ailleurs, dans le mode de réalisation représenté, la paroi de fermeture aval. 57 est mobile et portée par un vérin 58 (ou autre moyen de translation verticale) permettant de la déplacer entre une position de travail dans laquelle elle obture le réacteur et une position de chargement où elle est écartée de celui-ci.

Dans, la position de travail, un joint d'étanchéité torique 59 vient en appui contre une bride annulaire 60 en vue d'assurer l'étanchéité ; un verrouillage dans cette position peut le cas échéant être prévu.

La bride 60 (de forme creuse en vue de permettre la circulation d'un fluide de refroidissement) coopère avec des ressorts de soutien tels que 61 guidés par des colonnettes-supports 62. Le réacteur est ainsi soutenu par ces ressorts lorsque la paroi 57 est abaissée vers sa position de chargement, cependant que la compression du joint 59 lors du déplacement vers la position de travail s'effectue de façon progressive et élastique, avec la faculté de régler l'effort de compression.

De plus, dans le mode de réalisation représenté, le support de substrats 63 est porté par la paroi de fermeture 57 par l'entremise d'une platine tournante 64. Cette dernière est montée sur des moyens de guidage en rotation 65 et est associée à des moyens d'entrainement 66 permettant de la faire tourner autour de l'axe vertical X du réacteur.

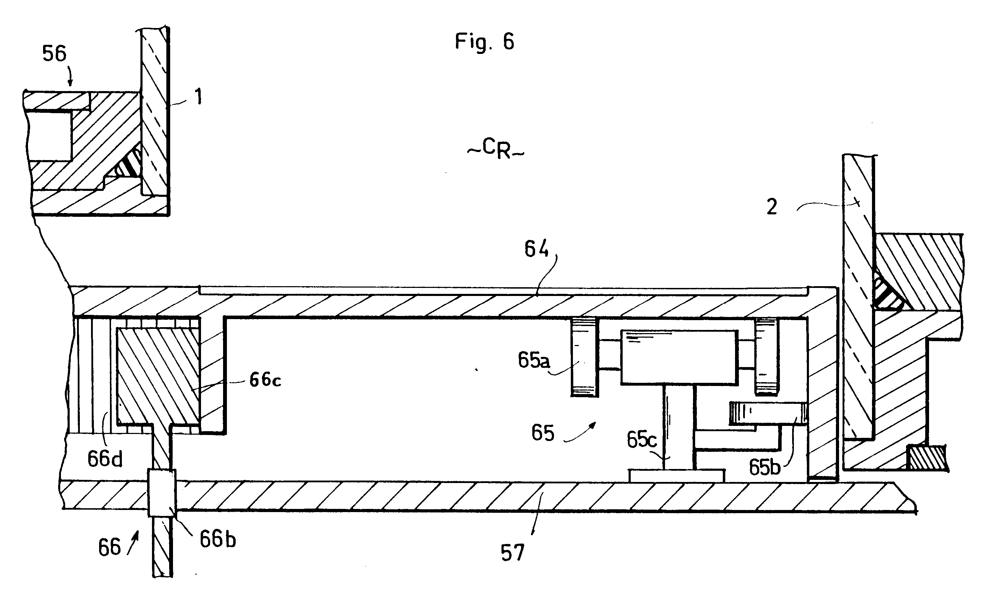

Ces moyens de guidage et d'entraînement sont schématisés à la figure 6. Les moyens de guidage en rotation comprennent, d'une part, des galets tels que 65a d'axe horizontal, sur lesquels vient en appui la sous-face de la platine 64, d'autre part, des galets tels que 65b d'axe vertical contre lesquels vient en appui un rebord périphérique de la platine. Plusieurs ensembles de guidage de ce type sont répartis autour de la platine et fixés par des piètements 65c sur la paroi 57. Les moyens d'entrainement 66 comprennent un moteur électrique 66a entraînant par l'entremise d'un arbre vertical et d'un joint tournant 66b un pignon 66c en prise dans une couronne dentée 66d qui est solidaire de la platine 64.

Ainsi, les plaquettes à revêtir 5 qui sont disposées sur le support 63 porté par la platine 64 peuvent être amenées à tourner autour de l'axe vertical X du réacteur, soit en position de chargement afin d'opérer leur chargement ou déchargement, soit éventuellement en position de travail à l'intérieur de la chambre annulaire de réaction.

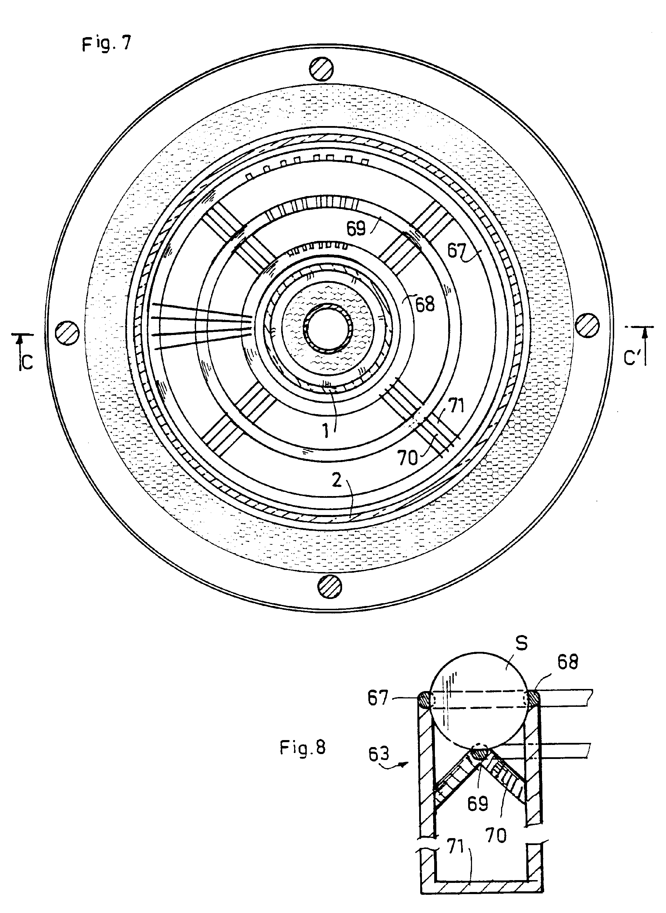

Comme l'illustrent les figures 7 et 8, en l'exemple le support 63 est constitué par trois guides circulaires sensiblement horizontaux, deux 67 et 68 au même niveau (au voisinage de la paroi interne et de la paroi externe), l'autre 69 de rayon intermédiaire à un niveau inférieur. Ces guides sont liés par des entretoises 70 à des piètements 71 reposant sur la platine 64.

Les guides 67, 68 et 69 sont datés d'une pluralité d'encoches sur leur pourtour afin de permettre d'y insérer les plaquettes 5. Chaque plaquette se trouve ainsi maintenue en position verticale radiale par deux zones latérales et une zone inférieure comme le schématise la figure 8.

## Revendications

1. Réacteur de dépôt ou traitement de surface pour revêtir ou traiter en surface une pluralité de substrats (S), comprenant, en combinaison :
   – une première paroi tubulaire étanche, dite paroi interne (1), chimiquement stable à haute température, s'étendant autour d'un axe longitudinal (X) et délimitant intérieurement un volume dit volume central ($V_C$),
   – une seconde paroi tubulaire étanche, dite paroi externe (2), chimiquement stable à haute température, s'étendant autour de la première paroi tubulaire pour délimiter avec celle-ci une chambre annulaire de réaction ($C_R$),
   – deux parois de fermeture (4, 8 ; 50, 57), agencées pour pouvoir obturer étanchément ladite chambre annulaire ($C_R$) à ses deux extrémités longitudinales,
   – une enceinte périphérique (26) s'étendant autour de la paroi tubulaire externe (2) sur au moins une fraction de la hauteur de celle-ci,
   – des moyens de distribution de gaz (16-18 ; 51-53), adaptés pour délivrer une phase gazeuse à l'intérieur de la chambre annulaire de réaction ($C_R$) au voisinage d'une des parois de fermeture, dite paroi amont, lesdits moyens de distribution étant agencés pour répartir ladite phase gazeuse sur 360° dans ladite chambre annulaire,
   – des moyens d'aspiration (19, 20 ; 54-56), agencés pour aspirer la phase gazeuse après réaction au voisinage de la paroi de fermeture opposée, dite paroi aval, de façon à préserver la répartition en couronne de l'écoulement gazeux à l'intérieur de la chambre annulaire de réaction,
– un premier ensemble de chauffage (21) agencé à l'intérieur du volume central $(V_C)$ de façon à pouvoir transmettre vers la paroi tubulaire interne (1) un flux calorifique réparti sur 360°,
– un second ensemble de chauffage (27) disposé dans l'enceinte périphérique (26) de façon à pouvoir transmettre vers la paroi tubulaire externe (2) un flux calorifique réparti sur 360°,
– des moyens de régulation thermique, adaptés pour asservir les premier et second ensembles de chauffage de sorte que les flux calorifiques transmis à travers les parois interne et externe tendent à assurer un profil longitudinal de température prédéterminée dans la chambre annulaire de réaction sur une portion de la hauteur de celle-ci, dite portion de travail $(Z_t)$,
– un support de substrats (32, 63), de forme adaptée pour se loger dans la chambre annulaire de réaction $(C_R)$ et pour positionner les substrats (S) dans la portion de travail de ladite chambre annulaire.

2. Réacteur selon la revendication 1, caractérisé en ce que :
. les moyens de distribution de gaz comprennent un conduit d'arrivée (16) relié à un réseau de conduits de répartition (18) agencés en regard de la paroi de fermeture amont (4), ledit réseau étant connecté à des entrées (4a) ménagées dans ladite paroi de fermeture amont et réparties autour de l'axe (X) pour déboucher dans la chambre annulaire de réaction $(C_R)$,
. les moyens d'aspiration comprennent un collecteur de pompage (19) relié à un réseau de conduits d'aspiration (20) agencés en regard de la paroi de fermeture aval (8), ledit réseau étant connecté à des sorties ménagées dans ladite paroi de fermeture aval et réparties autour de l'axe (X) pour déboucher dans la chambre annulaire de réaction $(C_R)$.

3. Réacteur selon la revendication 1, caractérisé en ce que :
. les moyens de distribution de gaz comprennent un conduit d'arrivée (51) relié à un réseau de conduits de répartition (52) agencés en regard de la paroi de fermeture amont (50), ledit réseau étant connecté à des entrées ménagées dans ladite paroi de fermeture amont et réparties autour de l'axe (X) pour déboucher dans la chambre annulaire de réaction $(C_R)$,
. les moyens d'aspiration comprennent un collecteur de pompage (54) pénétrant dans le volume central $(V_c)$ du côté de la paroi de fermeture amont (50) et s'étendant le long de celui-ci pour déboucher à travers un fond (56) obturant ledit volume central, ledit fond étant agencé en regard de la paroi de fermeture aval (57) de façon que la phase gazeuse puisse s'écouler dans le sens centripète entre ce fond et cette paroi, depuis la chambre annulaire de réaction $(C_R)$ vers le collecteur (54).

4. Réacteur selon la revendication 1, caractérisé en ce que :
. les moyens de distribution de la phase gazeuse comprennent un collecteur de distribution pénétrant dans le volume central du côté de la paroi de fermeture aval et s'étendant le long de celui-ci pour déboucher à travers un fond obturant ledit volume central, ledit fond étant agencé en regard de la paroi de fermeture amont de façon que la phase gazeuse puisse s'écouler dans le sens centrifuge entre ce fond et cette paroi, depuis le collecteur vers la chambre annulaire de réaction,
. les moyens d'aspiration comprennent un collecteur de pompage relié à un réseau de conduits d'aspiration agencés en regard de la paroi de fermeture aval, ledit réseau étant connecté à des sorties ménagées dans ladite paroi de fermeture aval et réparties autour de l'axe pour déboucher dans la chambre annulaire de réaction.

5. Réacteur selon l'une des revendications 2, 3 et 4, caractérisé en ce que l'une des parois de fermeture (57) est mobile et portée par des moyens de translation (58) adaptés pour permettre de la déplacer entre deux positions, l'une, dite de travail, où ladite paroi obture étanchément la chambre annulaire de réaction $(C_R)$ à son extrémité longitudinale, l'autre, dite de chargement, où ladite paroi est écartée de cette extrémité et la laisse ouverte, le support de substrats (63) étant porté par ladite paroi de fermeture de façon à se déplacer avec celle-ci entre une position de travail intérieure à la chambre annulaire de réaction et une position de chargement extérieure.

6. Réacteur selon la revendication 5, caractérisé en ce que le support de substrats (63) est porté par la paroi de fermeture par l'entremise d'une platine tournante (64), ladite platine étant montée sur des moyens de guidage en rotation (65) et associé à des moyens (66) d'entraînement en rotation autour de l'axe longitudinal (X).

7. Réacteur selon l'une des revendications 1, 2, 3, 4, 5 ou 6, caractérisé en ce que les moyens de régulation thermique comprennent :
. des capteurs de température (30, 31) disposés, d'une part, sur la surface interne de la paroi tubulaire interne (1), d'autre part, sur la surface externe de la paroi tubulaire externe (2),
. et une unité d'asservissement agencée pour recevoir les informations de température issues des capteurs et adaptée pour commander les ensembles de chauffage (21, 27) de façon à réduire les écarts entre les températures détectées et des températures de consigne, correspondant au profil de températures désiré.

8. Réacteur selon la revendication 7, dans lequel les ensembles de chauffage sont de nature électrique, caractérisé en ce que :

– chaque ensemble de chauffage (21, 27) est divisé en plusieurs sous-ensembles (21a-21c ; 27a-27c) commandés séparément et longitudinalement juxtaposés,

– des capteurs de température (30a-30c ; 31a-31c) sont positionnés au niveau des divers sous-ensembles de chauffage,

– l'unité d'asservissement est adaptée pour commander chaque sous-ensemble de chauffage en fonction des informations de température issues du ou des capteurs correspondants de façon, pour chaque sous-ensemble, à réduire les écarts entre la température détectée et une température de consigne affectée audit sous-ensemble.

9. Réacteur selon la revendication 8, permettant de réaliser sensiblement une homogénéité de température dans la portion de travail ($Z_t$) de la chambre annulaire de réaction, caractérisé en ce que :

– chaque ensemble de chauffage (21, 27) est divisé en trois sous-ensembles juxtaposés, l'un intermédiaire (21a, 27a) situé au niveau de la portion de travail ($Z_t$) et les deux autres marginaux situés de part et d'autre (21b,c ; 27b,c),

– l'unité d'asservissement est adaptée pour augmenter le flux calorifique fourni par chaque sous-ensemble de chauffage en cas d'écart négatif entre la température détectée au niveau dudit sous-ensemble et une température de consigne identique pour tous les sous-ensembles, et pour réduire ce flux dans le cas contraire.

10. Réacteur selon l'une des revendications 1, 2, 3, 4, 5, 6, 7, 8 ou 9, adapté pour traiter une pluralité de substrats constitués chacun par une plaquette (S) d'épaisseur faible par rapport à ses autres dimensions, dans lequel le support de substrats (32, 63) présente une forme générale annulaire et délimite sur son pourtour une pluralité de logements, chacun adapté au maintien d'une plaquette (S) en position radiale ou voisine de la position radiale.

11. Réacteur selon la revendication 10, appelé à fonctionner avec son axe (X) sensiblement vertical, caractérisé en ce que le support de substrats (63) comprend des guides circulaires sensiblement horizontaux (67-69), liés par des entretoises (70) à des piètements (71), lesdits guides circulaires étant pourvus d'encoches sur leur pourtour agencées pour pouvoir maintenir chaque plaquette (S) en position verticale radiale par des zones latérales et inférieures de celle-ci.

12. Réacteur selon la revendication 10, appelé à fonctionner avec son axe (X) sensiblement vertical, les plaquettes (S) étant prépositionnées par lots sur des nacelles (N) où elles sont rangées dans des plans parallèles, caractérisé en ce que le support de substrats (32) comprend un bâti annulaire ajouré (32b, 32c), pourvu de moyens (32a) de positionnement d'une pluralité de nacelles sur son pourtour, lesdits moyens de positionnement étant adaptés pour disposer chaque nacelle de sorte que la plaquette centrale de celle-ci se trouve en position verticale radiale dans la chambre annulaire de réaction ($C_R$).

13. Application d'un réacteur conforme à l'une des revendications précédentes, pour la réalisation d'un dépôt en phase vapeur (CVD) sur la surface des substrats.

14. Réacteur selon l'une des revendications 1 à 12 pour effectuer un dépôt chimique en phase vapeur de films conducteurs, semi-conducteurs ou isolants en vue de la fabrication de composants ou circuits électroniques, caractérisé en ce que la paroi tubulaire interne (1) et la paroi tubulaire externe (2) sont des parois cylindriques en matériau réfractaire de haute stabilité thermique, maintenues par des brides annulaires (3, 6, 7, 9, 10, 12, 13) à leurs extrémités longitudinales, le support de substrats (32, 63) étant lui-même en matériau réfractaire de haute stabilité thermique.

15. Réacteur selon la revendication 14, dans lequel les parois tubulaires interne (1) et externe (2), de même que le support de substrat, sont en quartz.

**Claims**

1. Reactor for surface deposition or treatment for coating or treating a plurality of substrates (S) on the surface, comprising in combination :

– a first impervious tubular wall, the so-called inner wall (1), which is chemically stable at high temperature, extending about a longitudinal axis (X) and delimiting internally a volume, the so-called central volume ($V_C$),

– a second impervious tubular wall, the so-called outer wall (2), which is chemically stable at high temperature, extending about the first tubular wall so as to delimit, together with the latter, an annular reaction chamber ($C_R$),

– two closure walls (4, 8; 50, 57), so designed as to be capable of tightly blocking said annular chamber ($C_R$) at its two longitudinal ends,

– a peripheral surround (26) extending about outer tubular wall (2) over at least a fraction of the height of the latter,

– gas distribution means (16-18; 51-53), so designed as to deliver a gaseous phase inside annular reaction chamber ($C_R$) close to one of the closure walls, the so-called upstream wall, said distribution means being so arranged as to distribute, within said annular chamber, said gaseous phase over 360°,

– aspiration means (19, 20; 54-56), so designed as to aspirate the gaseous phase after reaction near the opposite closure wall, the so-called downstream wall, so as to maintain the circular distribution of the gaseous flow inside the annular reaction chamber,

– a first heating assembly (21) arranged inside central space ($V_C$) so as to be capable of transmitting a calorific flow distributed over 360° to inner tubular wall (1),

– a second heating assembly (27) arranged within peripheral surround (26) so as to be capable of transmitting a calorific flow distributed over 360° to outer tubular wall (2),

– means for thermal regulation, so designed as to control the first and second heating assemblies in such a way that the calorific flows transmitted through the inner and outer walls tend to ensure a predetermined linear temperature profile within the annular reaction chamber over one section of the height of the latter, the so-called working section ($Z_t$),

– a support for the substrates (32, 63), of a shape capable of being accommodated within annular reaction chamber ($C_R$) and positioning the substrate (S) within the working section of said annular chamber.

2. Reactor according to claim 1, characterised in that :

. the gas distribution means comprise an inflow line (16) connected with a network of distribution lines (18) arranged opposite upstream closure wall (4), this network being connected with inlets (4a) provided in said upstream closure wall and distributed about axis (X) so as to open out into annular reaction chamber ($C_R$),

. the aspiration means comprise a pumping header (19) connected with a network of aspiration lines (20) arranged opposite downstream closure wall (8), said network being connected with outlets provided in said downstream closure wall and distributed about axis (X) so as to open out into annular reaction chamber ($C_R$).

3. Reactor according to claim 1, characterised in that :

. the gas distribution means comprise an inflow line (51) connected with a network of distribution lines (52) arranged opposite upstream closure wall (50), said network being connected with inlets provided in said upstream closure wall and distributed about axis (X) so as to open out into annular reaction chamber ($C_R$),

. the aspiration means comprise a pumping header (54) which penetrates central space ($V_C$) on the side of upstream closure wall (50) and extends along the latter so as to open out through a base (56) blocking said central space, whereby said base is arranged opposite downstream closure wall (57) so that the gaseous phase can flow in the centripetal direction between said base and said wall, from annular reaction chamber ($C_R$) to header (54).

4. Reactor according to claim 1, characterised in that :

. the means for distributing the gaseous phase comprise a distribution header which penetrates the central space on the side of the downstream closure wall and extends along the latter so as to open out through a base blocking said central space, said base being arranged opposite the upstream closure wall so that the gaseous phase can flow in the centrifugal direction between said base and said wall, from the header to the annular reaction chamber.

. the aspiration means comprise a pumping header connected with a network of aspiration lines arranged opposite the downstream closure wall, said network being connected with outlets arranged in said downstream closure wall and distributed about the axis so as to open out into the annular reaction chamber

5. Reactor according to one of claims 2, 3 and 4, characterised in that one of closure walls (57) is mobile and is supported by displacement means (58) so designed as to enable it to be moved between two positions, one, the so-called working position, in which said wall blocks annular reaction chamber ($C_R$) tightly at its longitudinal end, and another, the so-called loading position, in which said wall is moved away from said end and leaves it open, whereby substrate support (63) is supported by said closure wall so as to move with the latter between an inner working position within the annular reaction chamber and an outer loading position.

6. Reactor according to claim 5, characterised in that substrate support (63) is supported on the closure wall via a rotating plate (64), said plate being mounted on rotary guiding means (65) and linked with means (66) for rotary driving about longitudinal axis (X).

7. Reactor according to one of claims 1, 2, 3, 4, 5 or 6, characterised in that the means for thermal regulation comprise:

. temperature sensors (30, 31) arranged, on the one hand, on the inner surface of inner tubular wall (1), and on the other hand on the outer surface of outer tubular wall (2),

. and a control unit so designed as to receive temperature data emanating from the sensors and capable of controlling heating assemblies (21, 27) so as to reduce the differences between the measured temperatures and the design temperatures, corresponding to the required temperature profile.

8. Reactor according to claim 7, in which the heating assemblies are of electrical type, characterised in that :

– each heating assembly (21, 27) is divided into several sub-assemblies (21a-21c; 27a-27c) controlled separately and juxtaposed longitudinally,

– temperature sensors (30a-30c; 31a-31c) are positioned at the level of the various heating sub-assemblies,

– the control unit is so designed as to control each heating sub-assembly as a function of the temperature data emanating from the corresponding sensor or sensors so as to reduce, for each sub-assembly, the differences between the measured temperature and a design temperature assigned to said sub-assembly.

9. Reactor according to claim 8, making it possible to bring about substantially homogeneity of temperature within working section $(Z_t)$ of the annular reaction chamber, characterised in that :

– each heating assembly (21, 27) is divided into three juxtaposed sub-assemblies, an intermediate sub-assembly (21a, 27a) situated at the level of working section $(Z_t)$, while the two other marginal ones (21b,c; 27b,c) are situated on either side thereof,

– the control unit is so designed as to increase the calorific flow provided by each heating sub-assembly in case of a negative difference between the temperature measured at the level of said sub-assembly and a design temperature identical with all subassemblies, while reducing this flow in the contrary case.

10. Reactor according to one of claims 1, 2, 3, 4, 5, 6, 7, 8 or 9, so designed as to treat a plurality of substrates each constituted by a plate (S), the thickness of which is small by comparison with its other dimensions, in which substrate support (32, 63) is of generally annular shape and delimits on its periphery a plurality of seats, each capable of holding a plate (S) in radial position or next to the radial position.

11. Reactor according to claim 10, intended for operation with its axis (X) substantially vertical, characterised in that substrate support (63) comprises substantially horizontal circular guides (67-69), linked by struts (70) with base elements (71), said circular guides being provided with notches about their periphery so designed as to be capable of maintaining each plate (S) in radial vertical position at the lateral and lower zones of the latter

12. Reactor according to claim 10 intended to operate with its axis (X) substantially vertical, plates (S) being prepositioned in batches on carriers (N) where they are arranged in parallel planes, characterised in that substrate support (32) comprises a perforated annular frame (32b, 32c) provided with means (32a) for positioning a plurality of carriers on its periphery, said positioning means being so designed as to arrange each carrier in such a way that the central plate of the latter is in a vertical radial position within annular reaction chamber $(C_R)$.

13. Application of a reactor according to one of the preceding claims with a view to bringing about a vapour-phase deposit (CVD) on the surface of the substrates.

14. Reactor according to one of claims 1 to 12 for bringing about chemical deposition in the vapour phase of conductive, semi-conductive or insulating films with a view to producing electronic components or circuits, characterised in that inner tubular wall (1) and outer tubular wall (2) are cylindrical walls made from a refractory material of high thermal stability, secured at their longitudinal ends by annular flanges (3, 6, 7, 9, 10, 12, 13), whereby substrate support (32, 63) itself consists of a refractory material of high thermal stability.

15. Reactor according to claim 14, in which inner tubular walls (1) and outer tubular walls (2) as well as the substrate support consist of quartz.


**Patentansprüche**

1. Oberflächenbeschichtungs- oder -behandlungsreaktor zum Beschichten oder Behandeln an der Oberfläche einer Vielzahl von Substraten (S), umfassend in Kombination :

– eine erste dichte rohrförmige Wand, die sogenannte Innenwand (1), die bei hoher Temperatur chemisch stabil ist, sich um eine Längsachse (X) erstreckt und im Innern einen Raum, den sogenannten Mittelraum $(V_C)$, abgrenzt,

– eine zweite dichte rohrförmige Wand, die sogenannte Außenwand (2), die bei hoher Temperatur chemisch stabil ist und sich um die erste rohrförmige Wand erstreckt, so daß sie gemeinsam mit dieser eine ringförmige Reaktionskammer $(C_R)$ abgrenzt,

– zwei Verschlußwände (4, 8; 50, 57), die so beschaffen sind, daß sie besagte ringförmige Kammer $(C_R)$ an ihren beiden axialen Enden dicht abschließen können,

– ein peripheres Außengehäuse (26), das sich um die rohrförmige Außenwand (2) erstreckt, und zwar entlang mindestens eines Bruchteils der Höhe der besagten Außenwand,

– Gasverteilmittel (16-18; 51-53), die so beschaffen sind, daß sie in der Nähe einer der Verschlußwände, der sogenannten stromaufwärts gelegenen Wand, eine Gasphase ins Innere der ringförmigen Reaktionskammer $(C_R)$ fördern, wobei die besagten Verteilmittel so beschaffen sind, daß sie die besagte gasförmige Phase in der besagten ringförmigen Kammer über 360° verteilen,

– Ansaugmittel (19, 20; 54-56), die so beschaffen sind, daß sie nach Reaktion in der Nähe der gegenüber befindlichen Verschlußwand, der sogenannten stromabwärts gelegenen Wand, die gasförmige Phase ansaugen, so daß die kreisförmige Verteilung des Gasflusses innerhalb der ringförmigen Reaktionskammer gewahrt wird,

– eine erste Heizgruppe (21), die im Innern des Mittelraumes ($V_C$) so angeordnet ist, daß sie einen über 360° verteilten Wärmefluß an die rohrförmige Innenwand (1) übertragen kann,

– eine zweite Heizgruppe (27), die innerhalb des peripheren Außengehäuses (26) so angeordnet ist, daß sie einen über 360° verteilten Wärmefluß an die rohrförmige Außenwand (2) übertragen kann,

– Mittel für thermische Regelung, die so beschaffen sind, daß sie die ersten und zweiten Heizgruppen so steuern, daß die durch die Innen- und die Außenwand übertragenen Wärmeflüsse dazu neigen, in der ringförmigen Reaktionskammer entlang eines Teils der Höhe der besagten Kammer, der sogenannten Arbeitszone ($Z_t$), ein vorbestimmtes lineares Temperaturprofil zu gewährleisten,

– eine Substratabstützung (32, 63), die so geformt ist, daß sie sich in die ringförmige Reaktionskammer ($C_R$) einfügen läßt und die Substrate (S) in der Arbeitszone der besagten ringförmigen Kammer positioniert.

2. Reaktor nach Anspruch 1, dadurch gekennzeichnet,

. daß die Gasverteilmittel eine mit einem Netzwerk von Verteilrohren (18) verbundene Zuleitung (16) umfassen, wobei die besagten Verteilrohre gegenüber der stromaufwärts gelegenen Verschlußwand (4) angeordnet sind, und zwar ist das besagte Netzwerk mit in der besagten stromaufwärts gelegenen Verschlußwand angeordneten und rings um die Achse (X) verteilten Eingängen (4a) verbunden, um in die ringförmige Reaktionskammer ($C_R$) zu münden,

. daß die Ansaugmittel einen mit einem Netzwerk von Ansaugrohren (20) verbundenen Pumpsammler (19) umfassen, und zwar sind die besagten Ansaugrohre gegenüber der stromabwärts gelegenen Verschlußwand (8) angeordnet, wobei das besagte Netzwerk mit in der besagten stromabwärts gelegenen Verschlußwand angeordneten und um die Achse (X) verteilten Ausgängen verbunden ist, um in die ringförmige Reaktionskammer ($C_R$) zu münden.

3. Reaktor nach Anspruch 1, dadurch gekennzeichnet,

. daß die Gasverteilmittel eine mit einem Netzwerk von Verteilrohren (52) gegenüber der stromaufwärts gelegenen Verschlußwand (50) verbundene Zuleitung (51) umfassen, wobei das besagte Netzwerk mit in der besagten stromaufwärts gelegenen Verschlußwand vorgesehenen und rings um die Achse (X) verteilten Eingängen verbunden -, ist, um in die ringförmige Reaktionskammer ($C_R$) zu münden,

. daß die Ansaugmittel einen in den an der Seite der stromaufwärts gelegenen Verschlußwand (50) befindlichen Innenraum ($V_C$) eindringenden Pumpsammler (54) umfassen, wobei sich der besagte Pumpsammler entlang des besagten Innenraums erstreckt, um durch einen den besagten Innenraum verschließenden Boden (56) zu führen, und zwar ist der besagte Boden gegenüber der stromabwärts gelegenen Verschlußwand (57) angeordnet, so daß die gasförmige Phase in zentripetaler Richtung zwischen diesem Boden und dieser Wand von der ringförmigen Reaktionskammer ($C_R$) zu dem Sammler (54) strömen kann.

4. Reaktor nach Anspruch 1, dadurch gekennzeichnet,

. daß die Mittel zur Verteilung der gasförmigen Phase einen an der Seite der stromabwärts gelegenen Verschlußwand in den Mittelraum eindringenden Verteilsammler umfassen, wobei sich der besagte Sammler entlang des besagten Innenraums erstreckt, um durch einen den besagten Innenraum verschließenden Boden hindurch zu führen, und zwar ist der besagte Boden gegenüber der stromaufwärts gelegenen Verschlußwand angeordnet, so daß die gasförmige Phase in Zentrifugalrichtung zwischen diesem Boden und dieser Wand von dem Sammler zu der ringförmigen Reaktionskammer strömen kann,

. daß die Ansaugmittel einen mit einem Netzwerk von gegenüber der stromabwärts gelegenen Verschlußwand angeordneten Ansäugrohren verbundenen Pumpsammler umfassen, wobei das besagte Netzwerk mit in der besagten stromabwärts gelegenen Verschlußwand vorgesehenen und rings um die Achse verteilten Ausgängen verbunden ist, um in die ringförmige Reaktionskammer zu münden.

5. Reaktor nach einem der Ansprüche 2, 3 und 4, dadurch gekennzeichnet, daß die eine der Verschlußwände (57) beweglich und durch Verlagerungsmittel (58) abgestützt ist, wobei die besagten Verlagerungsmittel so beschaffen sind, daß sie die besagte Wand zwischen zwei Positionen, einer sogenannten Arbeitsposition, in der die besagte Wand die ringförmige Reaktionskammer ($C_R$) an ihrem axialen Ende dicht verschließt, und einer zweiten sogenannten Ladeposition verlagern, in der die besagte Wand von diesem Ende entfernt ist und es offenläßt, und zwar ist diese Substratstütze (63) durch die besagte Verschlußwand so abgestützt, daß sie gemeinsam mit dieser zwischen einer inneren Arbeitsposition in der ringförmigen Reaktionskammer und einer äußeren Ladeposition verlagert wird.

6. Reaktor nach Anspruch 5, dadurch gekennzeichnet, daß die Substratstütze (63) unter Zwischenschaltung einer sich drehenden Platte (64) durch die Verschlußwand abgestützt ist, wobei die besagte Platte auf Rotationsführungsmitteln (65) angeordnet ist und mit Mitteln (66) für drehenden Antrieb rings um die Längsachse (X) in Verbindung steht.

7. Reaktor nach einem der Ansprüche 1, 2, 3, 4, 5 oder 6, dadurch gekennzeichnet, daß die Mittel für thermische Regelung folgende Teile umfassen :

. Temperaturgeber (30, 31), die einerseits an der inneren Oberfläche der inneren rohrförmigen Wand (1) und andererseits an der äußeren Oberfläche der äußeren rohrförmigen Wand (2) angeordnet sind,

. sowie eine Steuereinheit, die so beschaffen ist, daß sie die von den Gebern gelieferten Temperaturdaten empfängt und in der Lage ist, die Heizgruppen (21, 27) so zu steuern, daß die Differenzen zwischen den gemessenen Temperaturen und den Solltemperaturen im Einklang mit dem gewünschten Temperaturprofil verringert werden.

8. Reaktor nach Anspruch 7, bei dem die Heizgruppen elektrischer Art sind, dadurch gekennzeichnet,

– daß jede Heizgruppe (21, 27) in mehrere Untergruppen (21a-21c; 27a-27c) untergeteilt ist, wobei die einzelnen Untergruppen getrennt gesteuert werden und der Länge nach aneinander anschließen,

– daß Temperaturgeber (30a-30c; 31a-31c) in Höhe der verschiedenen Unterheizgruppen angeordnet sind,

– daß die Steuereinheit so beschaffen ist, daß sie jede Unterheizgruppe in Abhängigkeit von den von dem bzw. den entsprechenden Geber(n) gelieferten Informationsdaten so steuert, daß bei jeder Untergruppe die Differenzen zwischen der gemessenen Temperatur und einer der besagten Untergruppe zugeteilten Solltemperatur verringert werden.

9. Reaktor nach Anspruch 8, bei dem es möglich ist, in der Arbeitszone $(Z_t)$ der ringförmigen Reaktionskammer im wesentlichen Homogenität der Temperatur zu erzielen, dadurch gekennzeichnet,

– daß jede Heizgruppe (21, 27) in drei aneinander anschließende Untergruppen untergeteilt ist, und zwar eine in Höhe der Arbeitszone $(Z_t)$ befindliche Zwischenuntergruppe (21a, 27a) und zwei weitere Randuntergruppen (21b,c; 27b,c) zu der einen und der anderen Seite der besagten Zwischenuntergruppe,

– daß die Steuereinheit so beschaffen ist, daß sie, falls zwischen der in Höhe der besagten Untergruppe gemessenen Temperatur und einer für alle Untergruppen identischen Solltemperatur eine negative Differenz besteht, den durch jede Heizuntergruppe gelieferten Wärmefluß erhöht und im gegenteiligen Falle diesen Fluß verringert.

10. Reaktor nach einem der Ansprüche 1, 2, 3, 4, 5, 6, 7, 8 oder 9, der so beschaffen ist, daß sich dadurch eine Vielzahl von Substraten behandeln läßt, wobei jedes der besagten Substrate in einem Plättchen (S) besteht, dessen Dicke im Verhältnis zu seinen anderen Maßen gering ist, und zwar hat bei dem besagten Reaktor die Substratstütze (32, 63) eine ringförmige Allgemeinform und grenzt an ihrer Peripherie eine Vielzahl von Lagerstellen ab, von denen jede zur Abstützung eines Plättchens (S) in radialer Lage oder in der radialen Lage benachbarter Lage geeignet ist.

11. Reaktor nach Anspruch 10 zum Betrieb mit im wesentlichen senkrechter Achse (X), dadurch gekennzeichnet, daß die Substratstütze (63) im wesentlichen waagerechte und durch Streben (70) mit Fußelementen (71) in Verbindung stehende kreisförmige Führungen (67-69) umfaßt, wobei die besagten kreisförmigen Führungen an deren Umfang Kerben aufweisen, die so beschaffen sind, daß sie jedes Plättchen (S) an dessen seitlichen und unteren Bereichen in radialer senkrechter Lage abstützen können.

12. Reaktor nach Anspruch 10 zum Betrieb mit im wesentlichen senkrechter Achse (X), bei dem die Plättchen (S) partieweise im voraus an Trägern (N) angeordnet werden, in denen sie sich in parallelen Ebenen befinden, dadurch gekennzeichnet, daß die Substratstütze (32) einen gelochten ringförmigen Rahmen (32b, 32c) mit Mitteln (32a) für die Anordnung einer Vielzahl von Trägern an seinem Umfang umfaßt, wobei die besagten Anordnungsmittel so beschaffen sind, daß sie jeden Träger so positionieren, daß sich dessen mittleres Plättchen in radialer senkrechter Lage in der ringförmigen Reaktionskammer $(C_R)$ befindet.

13. Anwendung eines Reaktors nach einem der vorstehenden Ansprüche zwecks Beschichtung in dampfförmiger Phase (CVD) der Oberfläche von Substraten.

14. Reaktor nach einem der Ansprüche 1 bis 12 für die chemische Beschichtung in dampfförmiger Phase von leitfähigen, halbleitfähigen oder isolierenden Filmen zwecks Fertigung von elektronischen Bestandteilen oder Schaltungen, dadurch gekennzeichnet, daß die rohrförmige Innenwand (1) und die rohrförmige Außenwand (2) zylindrische Wände aus feuerfestem Werkstoff hoher thermischer Stabilität sind, die an ihren Axialenden durch ringförmige Flansche (3, 6, 7, 9, 10, 12, 13) befestigt werden, wobei die Substratstütze (32, 63) selbst aus feuerfestem Werkstoff hoher thermischer Stabilität besteht.

15. Reaktor nach Anspruch 14, bei dem die rohrförmige Innenwand (1) und die rohrförmige Außenwand (2) ebenso wie die Substratstütze aus Quarz bestehen.

Fig. 1

Fig. 2

Fig.3

Fig. 4

Fig. 5

Fig. 6

~CR~

EP 0 371 065 B1

Fig. 7

Fig. 8